Europäisches Patentamt

European Patent Office

Office européen des brevets

(11) Publication number: **0 456 927 A1**

# EUROPEAN PATENT APPLICATION

(21) Application number: 90305273.6

(22) Date of filing: 16.05.90

(51) Int. Cl.⁵: **H01L 39/14, H01L 39/24**

(43) Date of publication of application:
**21.11.91 Bulletin 91/47**

(84) Designated Contracting States:
**DE FR GB**

(71) Applicant: **Boeke, Jan**
**32 Audley Lane**
**Chapel Hill, North Carolina 27514(US)**

(72) Inventor: **Boeke, Jan**
**32 Audley Lane**
**Chapel Hill, North Carolina 27514(US)**

(74) Representative: **Williams, John Francis et al**
**WILLIAMS, POWELL & ASSOCIATES 34**
**Tavistock Street**
**London WC2E 7PB(GB)**

(54) Superconducting wire and method of production thereof.

(57) A wire of superconductive material is produced by first forming a metal strip into a tube, sealing one tube end, filling the tube with a powder of superconductive material and drawing or pushing the filled tube through dies or rollers of progressively smaller sizes until a predetermined wire size is achieved and then heat treating the drawn wire to assure necessary crystallinity in the superconductor material.

Fig. 4.

EP 0 456 927 A1

The present invention relates to a wire or cable which is superconductive to electrical currents and a method of its manufacture.

Wires and cables used for conducting electricity are made of conducting metal with a wide variety of diameters and cross-sectional profiles. The wire may be surrounded by one or more layers of non-conducting material as insulation, and the insulation may again be surrounded by a shield of woven or solid metal. This again may be surrounded by a protective coating of rubber or polymers. Such an assembly of layers around multiple strands of wire is usually called a cable.

A specialized kind of wire conductor is used as the heating element in kitchen ranges and ovens. A metal conductor, usually made of a higher-resistivity alloy with a high melting point, is enclosed in a hollow tube of a high-temperature and corrosion-resistant alloy. The space between wire and tube is filled with a powdered fire-resistant material such as magnesium oxide which at all temperatures of use is a non-conductor of electricity. Such assembly is sealed at the ends and then drawn through a die of a desired size and configuration causing the tube and its contents to become thinner and longer. The drawing action is repeated until the tube has been reduced to the desired diameter and cross-sectional profile. The result is a stiff "shielded" wire where the central conducting wire is embedded in a highly compacted insulator and the whole assembly is protected by an external metal shell. Pieces of this wire can be cut and bent into a desired shape. At the ends the conducting core can be connected to current-carrying contacts in order to complete an electric circuit.

It has long been known that at sufficiently low temperatures certain materials become superconductors of electric currents by virtue of extremely low (or absence of) electrical resistance. Much research work is being directed to finding materials which will be superconducting at temperatures above the atmospheric boiling point of liquid nitrogen. So far, these materials have been found to be ceramic type materials. A ceramic is a composition of metallic elements and oxygen which is hard and brittle.
Such materials are more fully described in the extensive specialistic literature.

In transmitting electrical energy, a superconductor would be most useful in the form of a wire or cable. However, due to the hard and brittle nature of ceramic materials, the ceramic superconductors do not naturally lend themselves easily to such applications.

Accordingly, it is an object of the present invention to provide a means whereby superconductor materials can be formed into a wire or cable.

To obtain a wire of superconducting material according to the present invention, a strip of suitable metal or alloy is bent into a gutter. This gutter is filled with superconductive powder, and then closed by bending into a tube with a seam. This seam may or may not be sealed by welding or brazing. The tube with its contents is then drawn or pushed through dies or rollers of succeeding smaller diameters and of a desirable hole profile until a thinner wire of desired cross-sectional dimensions is obtained. When the desired wire diameter is obtained, the wire may be coiled to a solenoid or used straight or in any desired final shape, and then heated to a temperature required to give the ceramic superconductor the desired crystal characteristics.

Fig. 1. illustrates a wire section of this invention of circular cross-section.

Fig. 2. illustrates a wire cross-section of this invention of hexagonal cross-section.

Fig. 3. illustrates a wire cross- section of this invention having two layers around a superconductor.

Fig. 4. illustrates forming a U-shaped metal gutter in production of a wire of this invention.

Fig. 5. illustrates closing the U-shaped gutter into a tube by passing the formed gutter through a funnel-shaped device.

Fig. 6. illustrates reducing the diameter of a filled tube by rollers and size reducing dies.

In one embodiment of the present invention, which lends itself to continuous operation, an unlimited length of wire of any desired diameter can be produced. In this continuous process, a strip of metal or alloy of a suitable width and length is supplied in rolled form. If continuity of length is required, the beginning of a second roll may be welded onto the end of the first roll. The metal strip is bent and curved in its width between rollers into a cross-sectional U-shape to form a gutter. Superconductive powder or its precursor is poured into the U-shape of the gutter so formed and the gutter is drawn or pushed through an O-shaped opening, which opening may be shaped by rollers, or a die, thereby forming the gutter and contents into a closed tube. The initial part of the gutter is sealed with a conductive metal plug. The closed tube when so formed will have a seam which can be left as is, or can be sealed by continuous welding or brazing if this operation is deemed advantageous. By vibration the tube can be more fully filled solid with the powder. The tube so formed can be drawn or pushed through dies or rollers to compact the powder and to form the tube to any desired cross-sectional shape and diameter.

The formed tube can be provided with a layer concentric tube which will define an open space surrounding the formed tube. To provide the larger concentric tube, a wider metal strip may be formed into tubing around the filled tube to conduct coolant around the superconducting wire. The second concentric tube may be of another alloy than the first strip for instance for magnetic shielding, or the second strip may be of the same material as the first strip to reinforce the characteristics of the first strip.

To avoid contamination of the powder by the material of the strip at the heating operation for the crystallization of the superconductor, a barrier may be provided by coating, plating or cladding the strip on the side which will form the interior of the tube, with a suitable metal as for instance silver or another noble metal, or by providing a lining of glass-floc, nonwoven glass fabric or quartz-flakes or other suitable non-metallic material.

This barrier may be deposited on the strip, or a strip of the barrier-material may be fastened onto the metal strip, with a volatilizing adhesive, such as collodion, which volatilizes without residue at brazing, welding or recrystallization temperatures.

When the desired length of superconductive powder-filled tubing has been fabricated, the tubing may be closed with a plug or cap of conductive metal, to provide a terminal electrical contact.

The thickness of the outer metal layer and the size of the superconductor wire are determined by the dimensions of the initial strip, any interior coating, plating or cladding and the amount of superconductive material, as well as the number of size reductions. The metal thickness may be larger if the strip is made of a soft magnetic material and magnetic shielding of the resulting superconductive wire is envisioned. Alternatively, to obtain a greater thickness, a second or even third strip of the required material may be formed around the first tube.

The superconductive filling powder can be a variety of compositions which are well known to the art. All these ceramic superconductors suffer from the same prior drawback; i.e. they are not suitable to be formed by previously known methods into unlimited length wires which are of sufficient mechanical strength to withstand the strong magnetic forces which tend to disrupt the operation of any magnetic coil in which they are used. The wire produced according to the invention obviates this drawback, provided the metallic shielding effect of the tubing, or a second added shielding tubing, is strong enough to withstand these forces.

The present invention also provides method for producing a superconductor wire having a non-metallic supporting and/or insulating covering material such as glass. To obtain a glass-clad superconductor wire, a metal tube is lined with the desired glass cladding material and the lined tube is then filled with superconductor material. After producing the desired superconductor wire size and after bending or coiling the wire to a shape suitable for the desired uses, the superconductor is heat-treated to obtain the desired condition of superconductivity which treatment also fuses the glass of the liner onto the superconductor. The metal tubing-material can be subsequently removed by etching leaving a glass-clad superconductor wire. This glass-clad wire can be mechanically further reinforced by coating with a synthetic resin.

In yet another embodiment, which can be continuous, a cladded metal strip or a metal strip and a strip of glass felt or non-woven fabric can be wrapped around a mandrel so that the cladding or the glass layer lies between the metal strip and the mandrel. Preferably the mandrel should be hollow and serve as a funnel into which the superconductive powder is poured. As the winding progresses, a cylinder is formed continuously and the mandrel is slid out of the cylinder at the same rate in which the cylinder is formed and filled with superconductive powder.

Here also, the cylinder so formed will have a longitudinal or spiral seam which can be closed by welding, brazing or soldering. Alternatively, another tube can be soldered around the assembly to seal the seam.

When the end of the tube is reached, the tube is closed off with a conducting cap or plug as an electrical terminal, and its diameter reduced as described above with subsequent heat-treated to crystallize the superconductor.

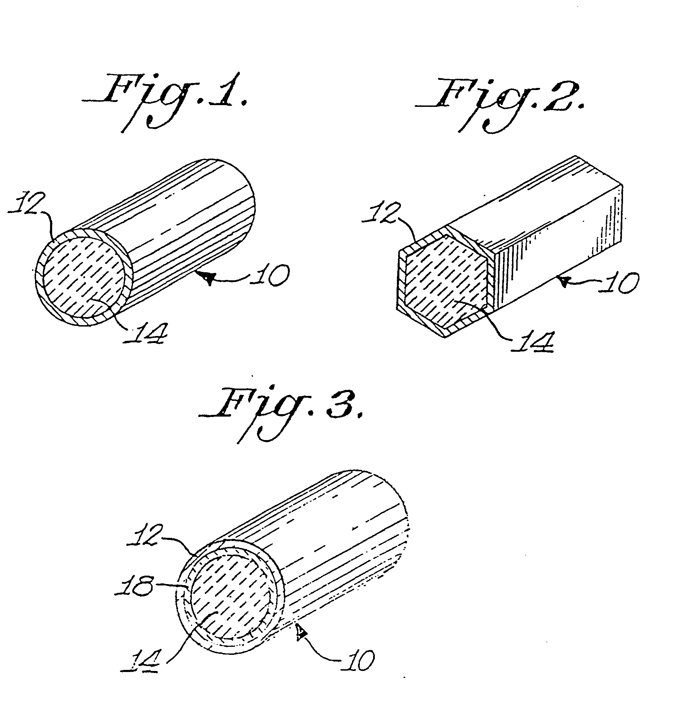

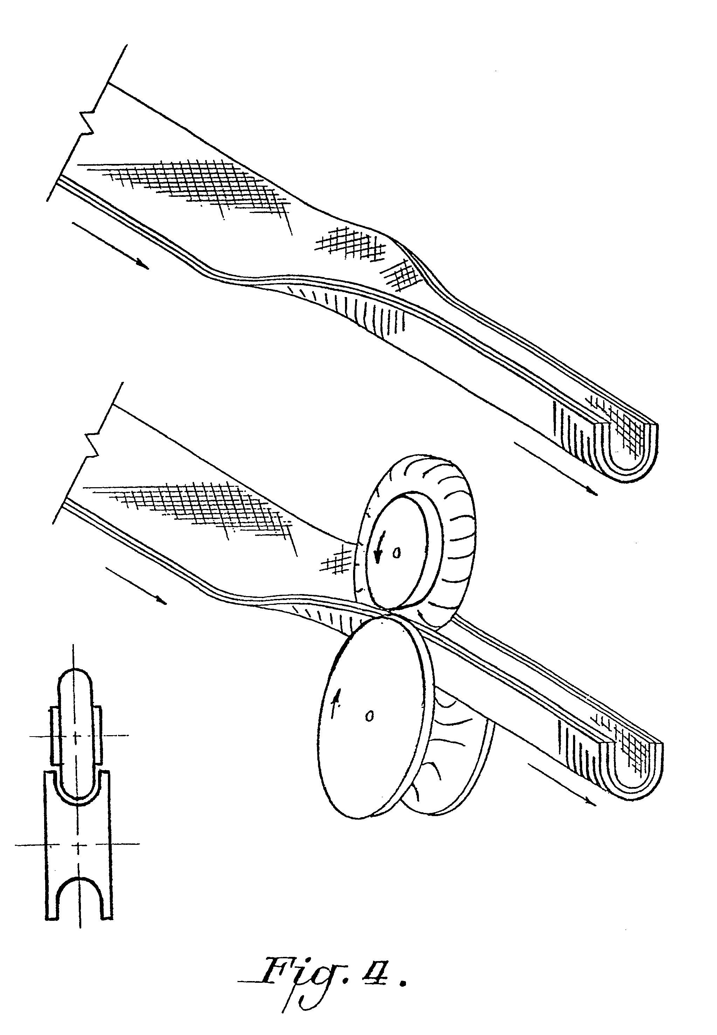

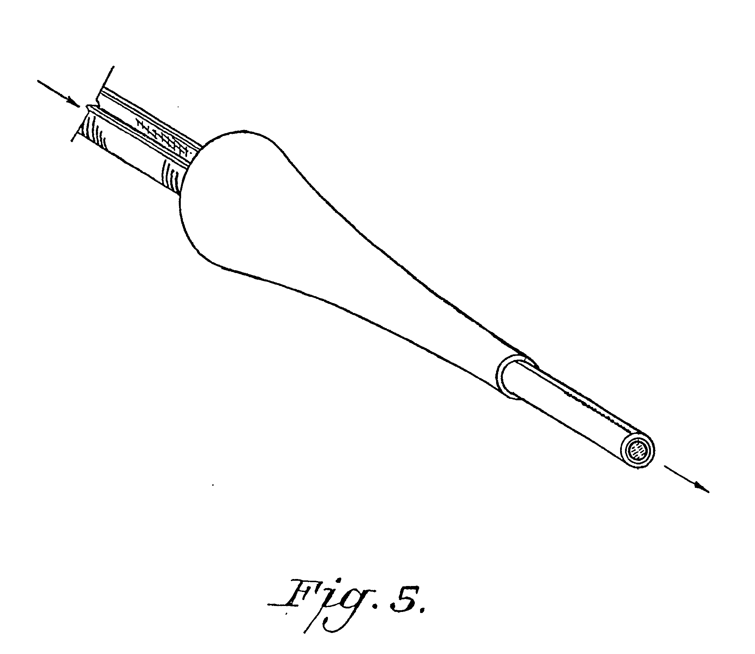

Fig. 1-3 illustrate a wire 10 of this invention wherein superconductor 14 is encased in metal 12. An intermediate encasing layer 18, such as glass, is shown in Fig. 3. The cross-sectioned configurations shown are circular and hexagonal but any desired cross-sectional shape or configuration can be formed including square, rectangular or any other polygon desired.

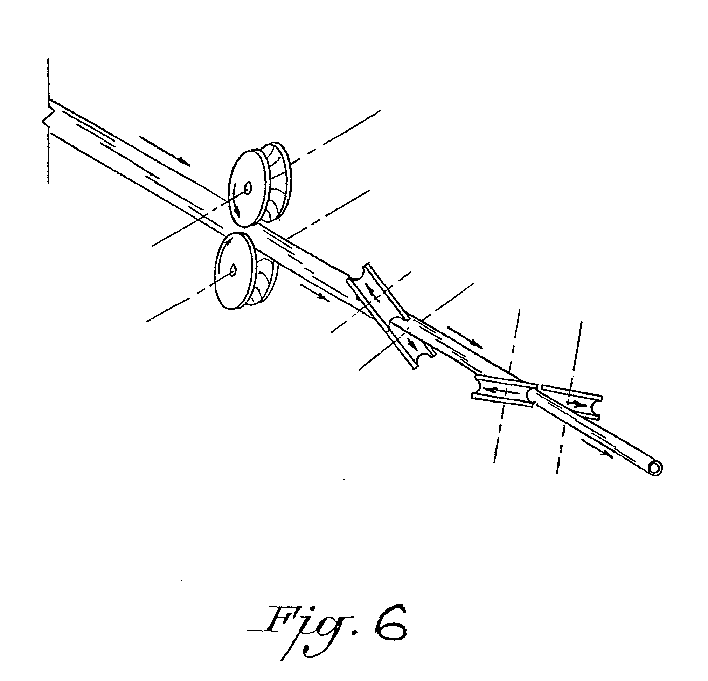

Fig. 4 illustrates forming a U-shaped gutter of a metal strip having an interior coating or layer of a second material. Fig. 5 illustrates a funnel-shaped device closing the gutter from Fig. 4 after semiconductor material is placed in the gutter to form a tube.

Fig. 6 illustrates reducing the diameter of the tube formed in Fig. 5.

In the superconductive state of the wire core, very high electrical currents can be carried by the wire without causing an appreciable voltage drop between the ends of the superconducting wire. Hence practically no current flows through the metal tube itself. Thus the metal tube acts as protective insulation for the superconductor. But if for some reason superconductivity of the core is reduced or lost, the core becomes a relatively poor conductor and the voltage between the ends of the wire will increase to a high value to maintain the current through the wire. Such high voltage would cause a high current through the metal shell which might cause excessive heating and destroy the wire assembly. For this reason, a fast-acting cut-out relay should be connected to both ends of the superconductor wire, electrically bridging the wire assembly. If an appreciable resistance arises and current begins to flow in the metal shell between the ends, this relay will immediately cut the connection of the wire with the rest of the electrical circuit and so prevent Joule-heating of the metal shell.

Having fully described the superconductive wire of the present invention, the following example serves to further illustrate a particular aspect of the invention without limitation thereupon.

A strip (for this example 1 meter long) of 1mm thick and 31:42 mm wide of soft pure iron sheet is heavily silver plated on one side. Between rollers, this strip is formed into a gutter with the silverplate inside. This gutter is forced down a shaping funnel which has an end opening of 10 mm diameter thereby forming the gutter into a tube of 10 mm outer diameter with seam 0.28 mm wide. The seal is brazed with silver solder as the tube exits the funnel. The beginning end of this tube is closed with a silver plug. After about 100 mm of tubing have been formed, the tubing is filled with commerically available powdered superconductor of the Y-Ba-Cu-O group (also known as the "1-2-3-group") which has a slightly deviating stoechiometric composition so as to "pin" the field in the superconductor. The superconductor powder filling is compacted by vibrating the tubing. When tubing of sufficient length has been filled, the diameter of the tubing is reduced by several sets of rollers, moving from the newly filled part toward the "beginning" of the tube which was plugged or capped by an end cap. This compacts the powder, reduces the diameter of the filled tubing or wire, and increases its length. Between size-reductions the filled tubing is heated to 400˚c to soften the work-hardened iron. The end of the tube is also plugged or capped with a silver cap forming the end contact. The end of the filled tube is rolled by the reducing rollers toward this end, so the powder is compacted against the plug.

The reduced-diameter wire is coiled on a metal mandrel to form a magnetic coil which is heated in a furnace in an inert atmosphere or vacuum to requirements prescribed by the powder supplier. Because the powder is occluded in a closed tube, it cannot lose oxygen during the heat treatment. The silver-plate acts as a barrier to prevent the powder from reacting with the iron of the tube. Before the coil is tested in liquid nitrogen, the windings and ends of the coil should be secured to prevent it from unwinding under the forces of its own magnetic field. The iron tube shields the superconductor from the magnetic field which tends to minimize the available conduction path, up to the saturation magnetization of the iron.

## Claims

1. A composite article which comprises a wire form of a crystalline superconductive material encased in materials of lower electrical conductivity of unlimited length and at least two means for electrical connection with said superconductor material.

2. A composite article according to claim 1, wherein at least one material of lower conductivity is a metallic material.

3. A composite material according to Claim 1, wherein one material of lower conductivity is glass.

4. A composite article according to Claim 3, which further comprises a layer of glass between said wire of crystalline superconductive material and a metallic material.

5. A composite article according to Claim 2, whereby the metallic material is protected from electrical overload by a means of sensing an electrical current through the metallic material and a means to interrupt the circuit when current flow is sensed through the metallic material.

6. A method for producing a composite article of a wire of superconducting material according to claim 1, which comprises:
   a) producing a hollow metal tube filled with a superconductive material,
   b) moving at least a portion of the filled tube through at least one size-reducing device whereby the diameter of the tube and its contents is reduced to a wire size, and
   c) heat treating the wire obtained to provide crystallinity in the superconductive material.

7. A method as claimed in Claim 6, wherein before filling one end of said tube is sealed with electrically conductive metal, and after filling the other end is similarly sealed.

8. A method according to claim 6, for the continuous production of a composite article which comprises:
   e) forming a strip of metal into a U-shaped gutter or forming the strip around a mandrel to form a cylinder.

f) filling said gutter or cylinder with a powder of a superconductor material.

g) sealing said gutter to create said hollow metal tube.

9. A method according to Claim 8, wherein the tube formed from the gutter and the formed cylinder have a longitudinal seam which is sealed by welding, brazing or soldering.

10. A method according to Claim 8, after the sealing step g), the hollow metal tube is encased in a second metal tube or cylinder.

11. A method according to Claim 6, wherein the hollow metal tube has an interior surface coating of a protective material which is substantially inert to both the metal tube and the superconductive material.

12. A method according to Claim 6, wherein the hollow metal tube is lined with a metal cladding.

13. A method according to Claim 6, wherein the hollow metal tube is lined with a glass material before being filled with the superconductor material.

14. A method according to Claim 13, wherein after the heat treatment c), the metal exterior of the drawn wire is removed.

15. A method according to Claim 14, wherein after the removal of the exterior metal, the superconductor wire is coated with a support material which is a synthetic resin.

16. A method according to any of Claims 6 to 15, wherein the cross-section of the drawn wire is square, rectangular, round or hexagonal.

Fig.1.

Fig.2.

Fig.3.

Fig. 4.

*Fig. 5.*

Fig. 6

**European
Patent Office**

**EUROPEAN SEARCH
REPORT**

Application Number

**EP 90 30 5273**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 281 474 (SUMITOMO) <br> * Column 6, lines 11-46; column 9, claim 1; column 10, claim 14; figures 1-4 * <br><br> – – – | 1-2,6-7, 11-12,16 | H 01 L 39/14 <br> H 01 L 39/24 |
| X | EP-A-0 292 684 (SUMITOMO) <br> * Column 7, lines 7-31; column 9, lines 35-42; column 10, lines 9-47; column 14, claims 1-3; column 15, claims 4-6; figures 1-3,10 * <br><br> – – – | 1,3-4,6, 12-13,16 | |
| X | EP-A-0 147 512 (LA METALLI INDUSTRIALE) <br> * Claims 1-5; figures 1-4 * <br><br> – – – | 1-2,6-11, 16 | |
| A | W. BUCKEL: "Supraleitung", 1972, pages 222-224, Physik Verlag, Weinheim, DE <br> * Page 223, full page * <br><br> – – – – – | 5 | |

| | |
|---|---|
| | **TECHNICAL FIELDS SEARCHED (Int. Cl.5)** |
| | H 01 L 39 |

The present search report has been drawn up for all claims

| Place of search | Date of completion of search | Examiner |
|---|---|---|
| The Hague | 29 November 90 | HAMMEL E.J. |

CATEGORY OF CITED DOCUMENTS

X : particularly relevant if taken alone
Y : particularly relevant if combined with another
    document of the same catagory
A : technological background
O : non-written disclosure
P : intermediate document
T : theory or principle underlying the invention

E : earlier patent document, but published on, or after
    the filing date
D : document cited in the application
L : document cited for other reasons

& : member of the same patent family, corresponding
    document